# EUROPÄISCHE PATENTSCHRIFT

(11) **EP 3 182 504 B1**
(45) Veröffentlichungstag und Bekanntmachung des Hinweises auf die Patenterteilung: **01.01.2020**
(21) Anmeldenummer: 16198697.1
(22) Anmeldetag: 14.11.2016
(51) Int. Cl.: H01P 5/107, H01Q 13/02, H01P 3/12, H05K 1/02

(54) **LEITERPLATTE FÜR HF-ANWENDUNGEN MIT INTEGRIERTER BREITBANDANTENNE**
PRINTED CIRCUIT BOARD FOR RF APPLICATIONS WITH INTEGRATED WIDEBAND ANTENNA
CIRCUIT IMPRIMÉ POUR APPLICATIONS HF À ANTENNE LARGE BANDE INTÉGRÉE

(30) Priorität: 16.12.2015 DE 102015225496
(43) Veröffentlichungstag der Anmeldung: 21.06.2017
(73) Patentinhaber: Airbus Defence and Space GmbH, 82024 Taufkirchen (DE)
(72) Erfinder: ZIEGLER, Volker, 85662 Hohenbrunn (DE); MIRALLES NAVARRO, Enric, 81373 München (DE)
(74) Vertreter: Isarpatent

(56) Entgegenhaltungen:
- US-A1- 2014 285 289
- US-A1- 2015 201 499
- US-A1- 2015 295 651
- US-B1- 6 185 354
- SCHULWITZ L ET AL: "A compact millimeter-wave horn antenna array fabricated through layer-by-layer stereolithography", ANTENNAS AND PROPAGATION SOCIETY INTERNATIONAL SYMPOSIUM, 2008. AP-S 2008. IEEE, IEEE, PISCATAWAY, NJ, USA, 5. Juli 2008 (2008-07-05), Seiten 1-4, XP031824449, ISBN: 978-1-4244-2041-4

## Beschreibung

### TECHNISCHES GEBIET DER ERFINDUNG

Die Erfindung betrifft eine Leiterplatte für HF-Anwendungen mit einer integrierten Breitbandantenne, insbesondere mit einem integrierten Hornstrahler, der in einem 3D-Druckverfahren hergestellt worden ist.

### TECHNISCHER HINTERGRUND

In Hochfrequenz-(HF)-Anwendungen werden breitbandige Antennenelemente üblicherweise an die in solchen HF-Anwendungen eingesetzten Leiterplatten über Steckverbindungen angeschlossen. Integrierte Antennenelemente, wie beispielsweise planare, in Leiterplattentechnik gefertigte Antennenelemente, weisen häufig nicht die erforderliche bzw. gewünschte Bandbreite für die jeweiligen HF-Anwendungen auf. Vorschläge zur Integration von breitbandigen Antennenelementen in Leiterplatten mit integrierten Wellenleitern sind beispielsweise in den Druckschriften US 6,185,354 B1, US 2014/285289 A1 und US 2010/0214185 A1 zu finden.

Stereolithographie ("stereolithography", SLA), selektives Lasersintern ("selective laser sintering", SLS) und selektives Laserschmelzen ("selective laser melting", SLM) gehören zur Gruppe der generativen Fertigungsverfahren und werden landläufig auch als "3D-Druckverfahren" bezeichnet. Dabei werden auf der Basis von geometrischen Modellen Datensätze erzeugt, die in einem speziellen generativen Fertigungssystem zur Herstellung von Objekten vordefinierter Form aus formlosen Materialien wie Flüssigkeiten und Pulvern formneutralem Halbzeugen wie etwa band-, draht- oder bahnförmigem Material mittels chemischer und/oder physikalischer Prozesse genutzt werden. 3D-Druckverfahren verwenden additive Prozesse, bei denen das Ausgangsmaterial schichtweise in vorgegebenen Formen sequentiell aufgebaut wird.

3D-Druckverfahren sind derzeit weit verbreitet in der Herstellung von Prototypen oder in der schnellen Produktentwicklung ("Rapid Product Development", RPD), in der eine ressourceneffiziente Prozesskette zur bedarfsgerechten Klein- und Großserienfertigung individualisierter Bauteile eingesetzt wird. 3D-Druckverfahren finden vielfältige Anwendung im Bauingenieurwesen, in der Architektur, in der Dentaltechnik, im Werkzeugbau, in der Implantologie, im Industriedesign, in der Automobilindustrie sowie auch in der Luft- und Raumfahrtindustrie.

3D-Drucker und speziell Lasersintervorrichtungen verwenden ein rechnergestütztes Konstruktionssystem ("computer-aided design", CAD) einerseits und eine Strahlanlage andererseits, welche den generativen Schichtaufbau des zu druckenden Objekts auf der Basis des von dem CAD-System bereitgestellten digitalen Fertigungsmodells durchführt. Ein dreidimensionales CAD-Modell des zu druckenden Objekts wird dabei einer zur Generierung der für die Strahlanlage notwendigen Steuerdaten durchgeführten Aufbereitungsprozedur unterzogen, dem sogenannten "Slicing". Dabei wird das CAD-Modell in Schichten vorgegebenen gleichmäßiger Dicke mit Schichtnormalen entlang der Aufbaurichtung der Strahlanlage digital zerlegt, welche dann die Basis für die Steuerung des Energiestrahls an der Ausgangsmaterialoberfläche in der Strahlanlage bilden. Ein herkömmlicher Schichtzerlegungsalgorithmus bildet dabei das CAD-Modell auf ein parkettiertes Oberflächenmodell ab, wodurch eine Menge geschlossener Kurven bzw. Oberflächenpolygone entstehen, die die sogenannten "Slices" zwischen zwei senkrecht durch Aufbaurichtung der Strahlanlage aufeinanderfolgenden Modellschnitte definieren.

Solche Oberflächenmodelle können zum Beispiel im für die Stereolithographie gängigen STL-Format gespeichert werden, welches die Oberflächengeometrie des dreidimensionalen zu druckenden Objekts als Rohdaten unstrukturierter Dreieckstexturen beschreibt. Die Strahlanlage liest die Oberflächenmodelldaten ein und setzt sie in ein entsprechendes Ansteuerungsmuster für den Laserstrahl in einem SLA-, SLS- oder SLM-Fertigungsverfahren um.

Durch 3D-Druckverfahren wie SLA, SLS oder SLM entsteht viel Designfreiraum bei der Fertigung komplexer dreidimensionaler Bauelemente und Komponenten hinsichtlich deren geometrischer Form und Struktur. Daher eignen sich 3D-Druckverfahren grundsätzlich für die Fertigung von breitbandigen Antennenelementen wie beispielsweise Hornantennen für transversalelektromagnetische Wellen, sogenannte TEM-Hornstrahler. Die Druckschriften Schulwitz L.; Mortazawi, A.: "A compact millimeter-wave horn antenna array fabricated through layer-by-layer stereolithography", IEEE Antennas and Propagat. Soc. Int. Symp., 5-11 July 2008 und "Design and Test of a 3D Printed Horn Antenna", Copper Mountain Technologies Whitepaper, Oktober 2015 (https://www.coppermountain tech.com/content/docs/library/3D_printing_horn_antenna-AMTA-web.pdf) zeigen derartige in 3D-Druckverfahren hergestellte Hornantennen bzw. Hornstrahler. Die Druckschrift US 2015/0201499 A1 offenbart 3D-Druckverfahren zur Erzeugung von funktionellen Komponenten für gedruckte Leiterplatten (PCBs).

### ZUSAMMENFASSUNG DER ERFINDUNG

Eine der Aufgaben der Erfindung besteht daher darin, Lösungen für die Integration von Antennenelementen in Leiterplatten für HF-Anwendungen zu finden, bei denen elektromagnetische Wellen möglichst breitbandig von der Leiterplatte auf die Antennenelemente geführt werden können.

Diese und andere Aufgaben werden durch eine Leiterplatte mit den Merkmalen des Anspruchs 1 und ein Herstellungsverfahren für eine Leiterplatte mit den Merkmalen des Anspruchs 3 gelöst.

Gemäß einem Aspekt der Erfindung umfasst eine Leiterplatte ("Printed Circuit Board", PCB) einen im Wesentlichen planaren Bauteilträger und einen Streifenleiter, welcher auf einer Oberfläche des Bauteilträgers aufgebracht ist. Der Streifenleiter erstreckt sich zu einem an einer Seitenkante des Bauteilträgers angeordneten Anschlussübergang. An diesem Anschlussübergang ist ein Hohlleiterabschnitt eines mittels eines 3D-Druckverfahrens hergestellten Antennenelements angekoppelt.

Gemäß einem weiteren Aspekt der Erfindung umfasst eine Leiterplatte ("Printed Circuit Board", PCB) ein mittels eines 3D-Druckverfahrens hergestelltes Antennenelement, welches einen Hohlleiterabschnitt und einen im Wesentlichen planaren, mit dem Hohlleiterabschnitt integral geformten Bauteilträgerabschnitt aufweist. Ein Streifenleiter ist auf einer Oberfläche des Bauteilträgerabschnitts aufgebracht und erstreckt sich zu einem an einer Seitenkante des Bauteilträgerabschnitts angeordneten Anschlussübergang.

Gemäß einem weiteren Aspekt der Erfindung umfasst ein Herstellungsverfahren für eine Leiterplatte die Schritte des generativen Fertigens eines Antennenelements mit einem Hohlleiterabschnitt, einem im Wesentlichen planaren, mit dem Hohlleiterabschnitt integral geformten Bauteilträgerabschnitt und einem Strahltrichterabschnitt mittels eines 3D-Druckverfahrens, und des Aufbringen eines Streifenleiters auf einer Oberfläche des Bauteilträgerabschnitts, welches sich zu einem an einer Seitenkante des Bauteilträgerabschnitts angeordneten Anschlussübergang erstreckt.

Eine der wesentlichen Ideen der Erfindung besteht darin, Antennenelemente in generativen schichtweisen Fertigungsverfahren, kurz "3D-Druckverfahren", herzustellen und deren Design in den Kontakt- bzw. Anschlussbereichen so zu gestalten, dass die Antennenelemente bei einem Anschluss an entsprechende Anschlussbereiche von Leiterplatten für HF-Anwendungen möglichst keine Impedanzänderung der Leitungsführung auf den Leiterplatten verursachen. Insbesondere bei Leiterplatten mit darauf aufgebrachten Streifenleitern (englisch "microstrips") können hochfrequente elektromagnetische Wellen über die Anschlussstelle der Antennenelemente damit sehr reflexionsarm und damit verlustarm von den Streifenleitern zur Antenne geführt werden.

3D-Druckprozesse zur Herstellung der Antennenelemente sind insbesondere deshalb vorteilhaft, da sie die Herstellung von dreidimensionalen Komponenten in urformenden Verfahren ermöglichen, ohne spezielles, auf die äußere Form der Komponenten abgestimmtes Fertigungswerkzeug zu benötigen. Dadurch werden hocheffiziente, Material sparende und Zeit sparende Herstellungsprozesse für Bauteile und Komponenten ermöglicht. Besonders vorteilhaft sind derartige 3D-Druckverfahren für Antennenelemente, da die Geometrie der verschiedenen funktionalen Komponenten der Antennenelemente speziell auf die sich teilweise stark kontrastierenden Anforderungen wie etwa Abstrahlungscharakteristik, Frequenzgang, Eingangsimpedanz oder Richtcharakteristik in solchen 3D-Druckverfahren mit geringen Kosten, geringer Fertigungsvorlaufzeit und mit geringer Komplexität in den für die Herstellung benötigten Fertigungsanlagen angepasst werden kann.

In 3D-Druckverfahren können Antennenelemente auch teilweise mit integral angeformten Bauteilträgern bzw. Teilen von Bauteilträgern hergestellt werden. Dadurch entfallen Probleme bei der Anbindung von Antennenelemente an Anschlussbereiche separater Bauteilträger vollständig und die Impedanzänderung am Hohlleiterabschnitt kann in vorteilhafter Weise minimal gehalten werden.

Überdies ist es erfindungsgemäß möglich, extrem breitbandige Antennen und Antennenarrays auf Leiterplatten zu integrieren, so dass ein vorteilhafter kompakter Aufbau solcher Leiterplatten möglich wird. Insbesondere für den Einsatz in hochfrequenten Schaltungsteilen, sogenannten HF-Frontendmodulen, beispielsweise in mobilen Kommunikationsgeräten eignen sich Leiterplatten für HF-Anwendungen mit geringer räumlicher Ausdehnung besonders gut.

Ferner ist es durch die Integration der generativ gefertigten Antennenelemente möglich, Limitierungen in der Breitbandigkeit zu umgehen, die durch Anschlussmaßnahmen wie etwa Steckverbindungen auftreten würden. Durch ein geeignetes und angepasstes Design der Antennenelemente können bestimmte Teile der Antennenelemente im Bereich der Anschlüsse an die Leiterplatte auch Funktionen zur mechanischen Stabilisierung des gesamten Aufbaus übernehmen, so dass der Anschluss der Antennenelemente erleichtert und Materialkosten eingespart werden können.

Vorteilhafte Ausgestaltungen und Weiterbildungen ergeben sich aus den weiteren Unteransprüchen sowie aus der Beschreibung unter Bezugnahme auf die Figuren.

Gemäß einer Ausführungsform der erfindungsgemäßen Leiterplatte kann das Antennenelement ein auf dem Hohlleiterabschnitt aufgebrachtes Streifenleitersegment aufweisen, das sich in Verlängerung zu dem Streifenleiter des Bauteilträgers auf dem Hohlleiterabschnitt erstreckt. Dabei können der Streifenleiter und das Streifenleitersegment an der Seitenkante des Bauteilträgers einen Hohlleiterübergang bilden.

Gemäß einer weiteren Ausführungsform der erfindungsgemäßen Leiterplatte kann das Antennenelement ein Hornstrahler sein, welcher einen an den Hohlleiterabschnitt anschließenden Strahltrichterabschnitt aufweist.

Gemäß einer weiteren Ausführungsform ist der Hohlleiterabschnitt des Antennenelements an dem Bauteilträger mittels des 3D-Druckverfahrens integral angeformt.

Gemäß eines erfindungsgemäßen Herstellungsverfahrens kann das Verbinden des Antennenelements mit dem Bauteilträger im Zuge des 3D-Druckverfahrens durch ein Anformen des Antennenelements an dem Bauteilträger erfolgen.

### KURZE INHALTSANGABE DER FIGUREN

Die vorliegende Erfindung wird nachfolgend anhand der in den schematischen Figuren angegebenen Ausführungsbeispiele näher erläutert. Es zeigen dabei:
Fig. 1 eine schematische Illustration der Schnittansicht einer Leiterplatte für HF-Anwendungen mit einem integrierten Antennenelement gemäß einem Beispiel der Erfindung,
Fig. 2 eine schematische Illustration der Draufsicht auf die Leiterplatte der Fig. 1,
Fig. 3 eine schematische Illustration der Schnittansicht einer Leiterplatte für HF-Anwendungen mit einem integrierten Antennenelement gemäß einem weiteren Beispiel der Erfindung,
Fig. 4 eine schematische Illustration der Draufsicht auf die Leiterplatte der Fig. 3,
Fig. 5 eine schematische Illustration der Schnittansicht einer Leiterplatte für HF-Anwendungen mit einem integrierten Antennenelement gemäß noch einem weiteren Beispiel der Erfindung,
Fig. 6 eine schematische Illustration der Schnittansicht einer Leiterplatte für HF-Anwendungen mit einem integrierten Antennenelement gemäß einer Ausführungsform der Erfindung,
Fig. 7 ein Blockdiagramm eines 3D-Druckverfahrens gemäß eines Beispiels der Erfindung, und
Fig. 8 ein Blockdiagramm eines 3D-Druckverfahrens gemäß einer Ausführungsform der Erfindung.

Die beiliegenden Figuren sollen ein weiteres Verständnis der der Erfindung vermitteln. Sie dienen im Zusammenhang mit der Beschreibung der Erklärung von Prinzipien und Konzepten der Erfindung. Die Elemente der Zeichnungen sind nicht notwendigerweise maßstabsgetreu zueinander gezeigt. Richtungsangebende Terminologie wie etwa "oben", "unten", "links", "rechts", "über", "unter", "horizontal", "vertikal", "vorne", "hinten" und ähnliche Angaben werden lediglich zu erläuternden Zwecken verwendet und dienen nicht der Beschränkung der Allgemeinheit auf spezifische Ausgestaltungen wie in den Figuren gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

### BESCHREIBUNG

3D-Druckverfahren im Sinne der vorliegenden Anmeldung umfassen alle generativen Fertigungsverfahren, bei welchen auf der Basis von geometrischen Modellen Objekte vordefinierter Form aus formlosen Materialien wie Flüssigkeiten und Pulvern formneutralem Halbzeugen wie etwa band-, draht- oder bahnförmigem Material mittels chemischer und/oder physikalischer Prozesse in einem speziellen generativen Fertigungssystem hergestellt werden. 3D-Druckverfahren im Sinne der vorliegenden Anmeldung verwenden dabei additive Prozesse, bei denen das Ausgangsmaterial schichtweise in vorgegebenen Formen sequentiell aufgebaut wird. 3D-Druckverfahren umfassen dabei insbesondere Stereolithographie ("stereolithography", SLA), selektives Lasersintern ("selective laser sintering", SLS), selektives Laserschmelzen ("selective laser melting", SLM), Schmelzschichtung ("fused deposition modelling", FDM bzw. "fused filament fabrication", FFF), und Elektronenstrahlschmelzen ("electron beam melting", EBM).

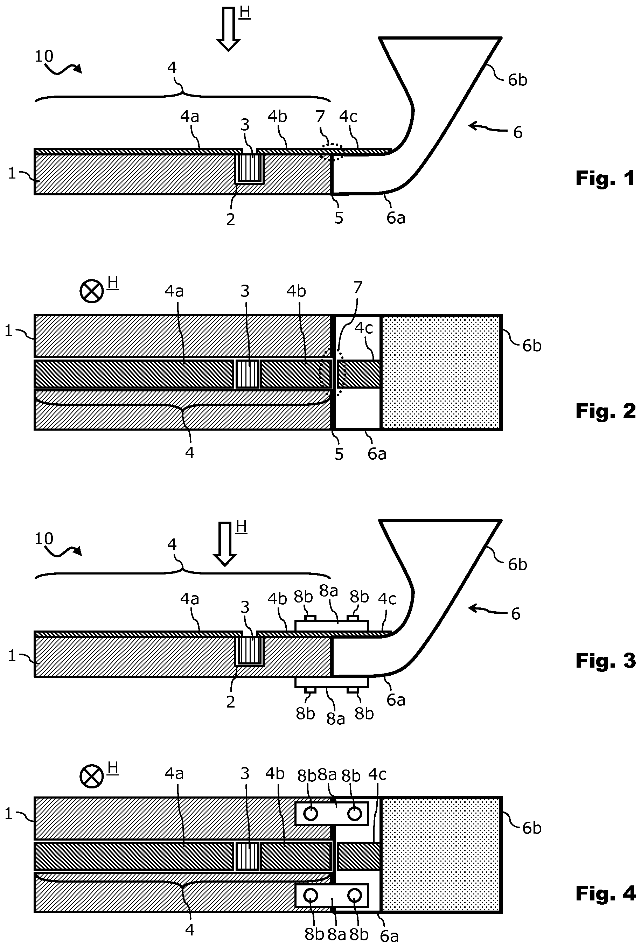

Fig. 1 zeigt eine schematische Illustration der Schnittansicht einer Leiterplatte 10 für HF-Anwendungen. Fig. 2 zeigt die Leiterplatte 10 der Fig. 1 in einer Draufsicht von oben, gekennzeichnet durch das Bezugszeichen "H". Die Leiterplatte 10 weist dabei ein integriertes Antennenelement 6 auf, beispielsweise einen Hornstrahler für transversale elektromagnetische Wellen (TEM). Es sollte dabei jedoch klar sein, dass die Ausgestaltung des Antennenelements 6 nicht auf Hornstrahler beschränkt ist, sondern auch anderen Antennenformen mit breitbandiger Abstrahlcharakteristik möglich sein können, d.h. Antennen, welche in einem Frequenzbereich im Hinblick auf bestimmte Abstrahleigenschaften einen vorgegebenen Standard einhält. Derartige breitbandige Antennenelemente können beispielsweise Vivaldi-Antennen, Reflektorantennen, Kegelantennen, Spiralantennen, YAGI-Antennen oder Wanderfeldantennen umfassen.

Der Hornstrahler 6 in Fig. 1 weist grundsätzlich einen Hohlleiterabschnitt 6a auf, der an einen Strahltrichterabschnitt 6b nahtlos angrenzt. Der Hohlleiterabschnitt 6a kann einen rechteckigen Hohlquerschnitt aufweisen und als Wellenleiter mit gasförmigem Dielektrikum dienen. Der Strahltrichterabschnitt 6b kann je nach gewünschten Strahleigenschaften ebenfalls einen rechteckigen Querschnitt aufweisen. Zudem kann der Strahltrichterabschnitt 6b ein Steghorntrichter, ein Exponentialhorntrichter oder eine beliebige andere geeignete Trichterform aufweisen.

Das Antennenelement 6, und in Fig. 1 insbesondere der Hornstrahler, ist dabei in einem 3D-Druckverfahren generativ gefertigt worden. Dazu kann das Antennenelement 6 zum Beispiel aus einem elektrisch leitfähigen Material gedruckt werden. Es kann aber auch möglich sein, das Antennenelement 6 aus einem elektrisch im Wesentlichen isolierenden Material zu drucken und die Innenund/oder Außenwände des gedruckten Antennenkörpers mit einem elektrisch leitfähigen Material zu beschichten.

Das Antennenelement 6 kann insbesondere einen Strahltrichterabschnitt 6b aufweisen, der integral mit einem Hohlleiterabschnitt 6a geformt ist. Der Hohlleiterabschnitt 6a kann zum Beispiel einen rechteckigen Querschnitt aufweisen. Der Strahltrichterabschnitt 6b kann, wie in den Fig. 1 bis 6 dargestellt, nach oben, d.h. um 90° gegenüber der Leiterplatte 10 abgewinkelt sein. Das Antennenelement 6 kann ein Streifenleitersegment 4c aufweisen, welches auf dem Hohlleiterabschnitt 6a aufgebracht ist. Dieses Streifenleitersegment 4c dient als Verlängerung eines Streifenleiters, welcher die elektromagnetische Wellen von der Leiterplatte in das Antennenelement 6 einspeist. Dazu kann sich das Streifenleitersegment 4c in Verlängerung zu dem Streifenleiter des Bauteilträgers 1 auf dem Hohlleiterabschnitt 6a erstrecken.

Der Bauteilträger 1 der Leiterplatte 10 ist im Wesentlichen planar und weist eine Hauptoberfläche auf, auf der ein oder mehrere Streifenleiter 4 aufgebracht sind. Die Streifenleiter 4 (englisch "microstrips") dienen zur Leitung von elektromagnetischen Wellen auf dem Bauteilträger 1. Zur signaltechnischen Einbindung von Chips oder anderen elektronischen Bauteilen (beispielhaft ist ein HF-Chip 3 in den Figuren dargestellt) kann der Streifenleiter 4 in verschiedenen Streifenleiterabschnitte 4a, 4b unterteilt werden. Der HF-Chip 3 kann zum Beispiel in einer Ausnehmung 2 in der Oberfläche des Bauteilträger 1 eingebettet werden, um die Wellenleitereigenschaften der Streifenleiterabschnitte 4a, 4b nicht substantiell zu beeinträchtigen.

Zumindest einer der Streifenleiterabschnitte 4b erstreckt sich auf der Oberfläche des Bauteilträgers 1 zu einem an einer Seitenkante des Bauteilträgers 1 angeordneten Anschlussübergang 5. Der Anschlussübergang 5 dient zur Ankopplung des Antennenelements 6, dessen Hohlleiterabschnitt 6a mit dem Anschlussübergang 5 des Bauteilträgers 1 gekoppelt ist. Der Streifenleiterabschnitt 4b ist dabei in Relation zu dem Streifenleitersegment 4c an der Seitenkante des Bauteilträgers 1 so gestaltet, dass die Streifenleiter 4b und 4c einen Hohlleiterübergang 7 bilden. Beispielsweise können der Streifenleiterabschnitt 4b und das Streifenleitersegment 4c an dem Hohlleiterübergang 7 durch eine Lötverbindung oder einen Bonddraht elektrisch verbunden sein, wie in Fig. 1 schematisch angedeutet.

Der Hohlleiterabschnitt 6a des Antennenelements 6 kann mit dem Bauteilträger 1 verschweißt oder verklebt sein. Es kann auch möglich sein, das Antennenelement 6 mit seinem Hohlleiterabschnitt 6a im Rahmen eines 3D-Druckverfahrens, beispielsweise im Rahmen des zur generativen Fertigung des Antennenelements 6 eingesetzten Herstellungsverfahrens, an dem Bauteilträger 1 integral anzuformen. Dabei kann der Bauteilträger 1 selbst als Ausgangssubstrat für den 3D-Druckprozess dienen, auf dem das Antennenelement 6 schichtweise aufgebaut wird.

Fig. 3 zeigt eine schematische Illustration der Schnittansicht einer Leiterplatte 10 für HF-Anwendungen. Fig. 4 zeigt die Leiterplatte 10 der Fig. 1 in einer Draufsicht von oben, gekennzeichnet durch das Bezugszeichen "H". Die Leiterplatte 10 der Fig. 3 und 4 unterscheidet sich von der in den Fig. 1 und 2 gezeigten Leiterplatte darin, dass Befestigungsplatten 8a vorgesehen sind, welche den Hohlleiterabschnitt 6a des Antennenelements 6 mit dem Bauteilträger 1 mechanisch verbinden. Dazu kann beispielsweise je eine Befestigungsplatte 8a auf der Unterseite und der Oberseite des Bauteilträgers 1 angeordnet werden, und die Befestigungsplatten 8a können mit Befestigungsstiften, -bolzen oder -schrauben miteinander verschraubt oder vernietet werden.

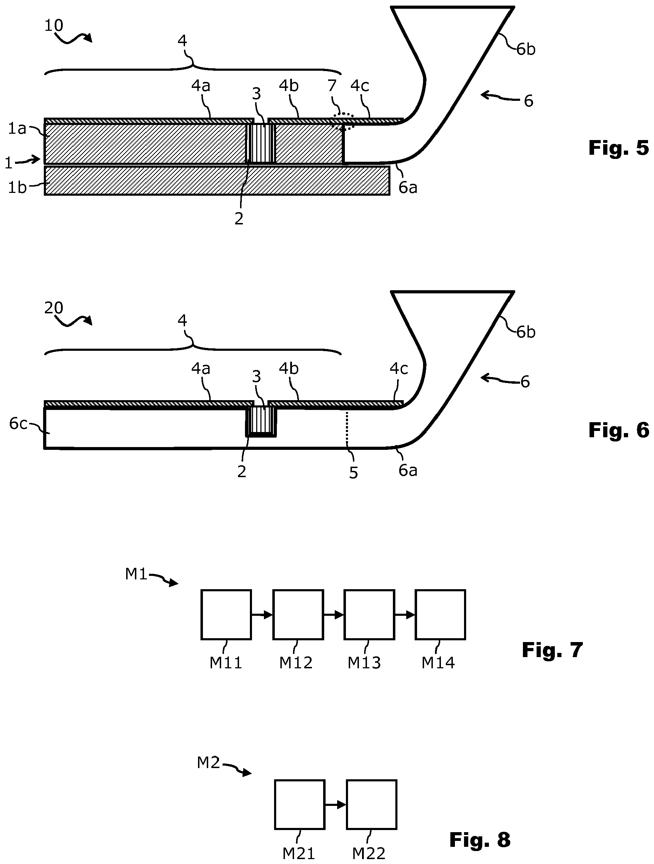

Fig. 5 zeigt eine schematische Illustration der Schnittansicht einer Leiterplatte 10 für HF-Anwendungen, bei der im Gegensatz zu den Leiterplatten 10 der Fig. 1 bis 4 der Bauteilträger 1 mindestens zwei übereinander gestapelte Leiterplattensubstrate 1a, 1b aufweist. Bei solchen Multilayer-Aufbauverfahren können die Leiterplattensubstrate 1a, 1b versetzt zueinander geschichtet werden, so dass ein Anschlussbereich auf dem unteren der zwei übereinander gestapelten Leiterplattensubstrate 1a, 1b entsteht, auf dem der Hohlleiterabschnitt 6a mechanisch stabil aufgebracht werden kann.

Fig. 6 zeigt eine schematische Illustration der Schnittansicht einer anderen Leiterplatte 20 für HF-Anwendungen. Im Gegensatz zu den Leiterplatten 10 in den Fig. 1 bis 5 wird für die Leiterplatte 20 ein Antennenelement 6 mithilfe eines 3D-Druckverfahrens hergestellt, so dass es neben dem Hohlleiterabschnitt 6a und gegebenenfalls dem Strahltrichterabschnitt 6b einen im Wesentlichen planaren, mit dem Hohlleiterabschnitt 6a integral geformten Bauteilträgerabschnitt 6c aufweist. Dieser Bauteilträgerabschnitt 6c dient dann als Bauteilträger statt eines herkömmlichen PCB-Substrats. Durch die integrale Ausbildung des Bauteilträgerabschnitts 6c zusammen mit dem Hohlleiterabschnitt 6a kann an dem Anschlussübergang 5 die Impedanz beider Abschnitte 6a, 6c unter optimaler Vermeidung von Reflexionsverlusten bei der Einspeisung von elektromagnetischen Wellen in den Hohlleiterabschnitt 6a angepasst werden.

Streifenleiterabschnitte 4a, 4b, welcher auf einer Oberfläche des Bauteilträgerabschnitts 6c aufgebracht werden und welche sich zu Anschlussübergang 5 erstrecken, können problemlos mit einem Streifenleitersegment 4c gekoppelt werden, welches sich in Verlängerung zu dem Streifenleiter 4a, 4b des Bauteilträgerabschnitts 1 auf dem Hohlleiterabschnitt 6a erstreckt.

In den Fig. 7 und 8 sind jeweils schematische Blockdiagramme von Herstellungsverfahren M1 und M2 für Leiterplatten gezeigt. Die Herstellungsverfahren können dabei insbesondere für die Herstellung von Leiterplatten 10 bzw. 20 gemäß den Fig. 1 bis 6 eingesetzt werden. Das Herstellungsverfahren M1 dient dabei der Herstellung einer Leiterplatte 10. Dabei wird zunächst ein Antennenelement 6 mit einem Hohlleiterabschnitt 6a und einem Strahltrichterabschnitt 6b mittels eines 3D-Druckverfahrens in einem Schritt M11 generativ gefertigt. In einem Schritt M12 wird das Antennenelement 6 mit einem im Wesentlichen planaren Bauteilträger 1 verbunden. Schließlich wird in Schritt M13 ein Streifenleiter 4a, 4b auf einer Oberfläche des Bauteilträgers 1 aufgebracht, welches sich zu einem an einer Seitenkante des Bauteilträgers 1 angeordneten Anschlussübergang 5 erstreckt, und in einem Schritt M14 das Antennenelement 6 mit dem Hohlleiterabschnitt 6a an dem Anschlussübergang 5 des Bauteilträgers 1 gekoppelt.

In Schritt M12 kann das Antennenelement 6 mit dem Bauteilträger 1 entweder im Zuge des 3D-Druckverfahrens durch integrales Anformen an den Bauteilträger 1 erfolgen. Alternativ kann das Antennenelement 6 mit dem Bauteilträger 1 auch verschweißt oder verklebt werden, oder es können eine oder mehrere Befestigungsplatten 8a eingesetzt werden, welche den Hohlleiterabschnitt 6a des Antennenelements 6 mit dem Bauteilträger 1 mechanisch verbindet.

Das Herstellungsverfahren M2 dient hingegen der Herstellung einer Leiterplatte 20 wie in Fig. 6 dargestellt. Dabei wird zunächst ein Antennenelement 6 mit einem Hohlleiterabschnitt 6a, einem im Wesentlichen planaren, mit dem Hohlleiterabschnitt 6a integral geformten Bauteilträgerabschnitt 6c und einem Strahltrichterabschnitt 6b mittels eines 3D-Druckverfahrens in einem ersten Schritt M21 generativ gefertigt. Dann wird in einem Schritt M22 ein Streifenleiter 4a, 4b auf einer Oberfläche des Bauteilträgerabschnitts 1 aufgebracht. Der Streifenleiter 4a, 4b erstreckt sich zu einem an einer Seitenkante des Bauteilträgerabschnitts 6c angeordneten Anschlussübergang 5.

Die beschriebenen Leiterplatten 10, 20 und deren Herstellungsverfahren M1, M2 können in Hochfrequenz-Frontends ("radio frequency front end", RFFE) für Sender und Empfänger in Mikrowellenkommunikationsgeräten, Satellitenkommunikationsgeräten, WiFi-Geräten, tragbaren Kommunikationsgeräten wie etwa Smartphones oder Tablets und ähnlichen Kommunikationsvorrichtungen eingesetzt werden.

In der vorangegangenen detaillierten Beschreibung sind verschiedene Merkmale zur Verbesserung der Stringenz der Darstellung in einem oder mehreren Beispielen zusammengefasst worden. Es sollte dabei jedoch klar sein, dass die obige Beschreibung lediglich illustrativer, keinesfalls jedoch beschränkender Natur ist.

In den Ansprüchen sowie der Beschreibung werden die Begriffe "beinhaltend" und "aufweisend" als neutralsprachliche Begrifflichkeiten für die entsprechenden Begriffe "umfassend" verwendet. Weiterhin soll eine Verwendung der Begriffe "ein", "einer" und "eine" eine Mehrzahl derartig beschriebener Merkmale und Komponenten nicht grundsätzlich ausschließen.

### LISTE DER BEZUGSZEICHEN

- 1: Bauteilträger
- 1a: Leiterplattensubstrat
- 1b: Leiterplattensubstrat
- 2: Ausnehmung
- 3: HF-Chip
- 4: Streifenleiter
- 4a: Streifenleiterabschnitt
- 4b: Streifenleiterabschnitt
- 4c: Streifenleitersegment
- 5: Anschlussübergang
- 6: Antennenelement
- 6a: Hohlleiterabschnitt
- 6b: Strahltrichterabschnitt
- 6c: Bauteilträgerabschnitt
- 7: Hohlleiterübergang
- 8a: Befestigungsplatte
- 8b: Befestigungsstift
- 10: Leiterplatte
- 20: Leiterplatte
- H: Draufsichtsrichtung
- M1: Herstellungsverfahren
- M11: Verfahrensschritt
- M12: Verfahrensschritt
- M13: Verfahrensschritt
- M14: Verfahrensschritt
- M2: Herstellungsverfahren
- M21: Verfahrensschritt
- M22: Verfahrensschritt

## Patentansprüche

1. Leiterplatte (20), umfassend:
ein gasförmiges Dielektrikum;
ein mittels eines 3D-Druckverfahrens hergestelltes Antennenelement (6),
welches einen Hohlleiterabschnitt (6a) mit rechteckigem Hohlquerschnitt, in welchem das gasförmige Dielektrikum vorhanden ist, und einen im Wesentlichen planaren, mit dem Hohlleiterabschnitt (6a) integral geformten Bauteilträgerabschnitt (6c) aufweist, wobei das Antennenelement (6) ein Hornstrahler ist, welcher einen an den Hohlleiterabschnitt (6a) anschließenden Strahltrichterabschnitt (6b) mit Trichterform aufweist; und
einen Streifenleiter (4a, 4b), welcher auf einer Oberfläche des Bauteilträgerabschnitts (6c) aufgebracht ist und welcher sich zu einem an einer Seitenkante des Bauteilträgerabschnitts (6c) angeordneten Anschlussübergang (5) erstreckt.

2. Leiterplatte (20) nach Anspruch 1, wobei das Antennenelement (6) ein auf dem Hohlleiterabschnitt (6a) aufgebrachtes Streifenleitersegment (4c) aufweist, das sich in Verlängerung zu dem Streifenleiter (4a, 4b) des Bauteilträgerabschnitts (1) auf dem Hohlleiterabschnitt (6a) erstreckt.

3. Herstellungsverfahren (M2) für eine Leiterplatte mit einem gasförmigen Dielektrikum, mit den Schritten:
generatives Fertigen (M21) eines Antennenelements (6) mit einem Hohlleiterabschnitt (6a) mit rechteckigem Hohlquerschnitt zur Aufnahme des gasförmigen Dielektrikums, einem im Wesentlichen planaren, mit dem Hohlleiterabschnitt (6a) integral geformten Bauteilträgerabschnitt (6c) und einem Strahltrichterabschnitt (6b), welcher sich an den Hohlleiterabschnitt (6a) anschließt und eine Trichterform aufweist, mittels eines 3D-Druckverfahrens; und
Aufbringen (M22) eines Streifenleiters (4a, 4b) auf einer Oberfläche des Bauteilträgerabschnitts (1), welches sich zu einem an einer Seitenkante des Bauteilträgerabschnitts (6c) angeordneten Anschlussübergang (5) erstreckt.

## Claims

1. Printed circuit board (20), comprising:
a gaseous dielectric;
an antenna element (6) produced by means of a 3D printing method and comprising a waveguide section (6a) having a rectangular hollow cross section, in which the gaseous dielectric is present, and a substantially planar component carrier section (6c) shaped integrally with the waveguide section (6a), wherein the antenna element (6) is a horn radiator comprising a beam funnel section (6b) adjacent to the waveguide section (6a) having a funnel shape; and
a microstrip (4a, 4b) applied on a surface of the component carrier section (6c) and extending to a connection transition (5) arranged at a lateral edge of the component carrier section (6c).

2. Printed circuit board (20) according to Claim 1, wherein the antenna element (6) comprises a microstrip segment (4c) applied on the waveguide section (6a) and extending on the waveguide section (6a) as an extension of the microstrip (4a, 4b) of the component carrier section (1).

3. Production method (M2) for a printed circuit board comprising a gaseous dielectric, comprising the following steps:
additive manufacturing (M21) of an antenna element (6) comprising a waveguide section (6a) having a rectangular hollow cross section for accommodating the gaseous dielectric, a substantially planar component carrier section (6c) shaped integrally with the waveguide section (6a), and a beam funnel section (6b) adjacent to the waveguide section (6a) and having a funnel shape, by means of a 3D printing method; and
applying (M22) a microstrip (4a, 4b) on a surface of the component carrier section (1), said microstrip extending to a connection transition (5) arranged at a lateral edge of the component carrier section (6c).

## Revendications

1. Circuit imprimé (20), comprenant :
un diélectrique sous forme gazeuse ;
un élément d'antenne (6) réalisé au moyen d'un procédé d'impression 3D, qui comporte une partie formant guide d'ondes (6a) ayant une section transversale creuse rectangulaire dans laquelle le diélectrique sous forme gazeux est présent, et une partie de support de composant (6c) sensiblement plane formée d'un seul tenant avec la partie formant guide d'ondes (6a), dans lequel l'élément d'antenne (6) est un élément rayonnant en cône qui comporte une partie rayonnante en entonnoir (6b) présentant une forme d'entonnoir et adjacente à la partie formant guide d'ondes (6a) ; et
un conducteur en ruban (4a, 4b) qui est appliqué sur une surface de la partie de support de composant (6c) et qui s'étend vers un raccord de jonction (5) disposé sur un bord latéral de la partie de support de composant (6c).

2. Circuit imprimé (20) selon la revendication 1, dans lequel l'élément d'antenne (6) comporte un segment de conducteur en ruban (4c) appliqué sur la partie formant guide d'ondes (6a) et s'étendant sur la partie formant guide d'ondes (6a) dans le prolongement du conducteur en ruban (4a, 4b) de la partie support de composant (1) .

3. Procédé de réalisation (M2) d'un circuit imprimé comportant un diélectrique sous forme gazeuse, comprenant les étapes suivantes :
la réalisation générative (M21), au moyen d'un procédé d'impression 3D, d'un élément d'antenne (6) qui comporte une partie formant guide d'ondes (6a) ayant une section transversale creuse rectangulaire pour recevoir le diélectrique sous forme gazeuse, une partie support de composant (6c) sensiblement plane formée d'un seul tenant avec la partie formant guide d'ondes (6a) et une partie rayonnante en entonnoir (6b) qui est adjacente à la partie formant guide d'ondes (6a) et présente une forme d'entonnoir ; et
l'application (M22) d'un conducteur en ruban (4a, 4b) sur une surface de la partie de support de composant (1) qui s'étend vers un raccord de jonction (5) disposé sur un bord latéral de la partie de support de composant (6c).
